# EUROPEAN PATENT APPLICATION

(11) **EP 4 675 677 A1**
(43) Date of publication of application: **07.01.2026**
(21) Application number: 24763558.4
(22) Date of filing: 08.02.2024
(51) Int. Cl.: H01L 23/12, H01L 23/34, H01L 31/02, H05K 1/02, H05K 3/46

(54) **SEMICONDUCTOR DEVICE, ELECTRONIC APPARATUS, AND METHOD FOR PRODUCING SEMICONDUCTOR DEVICE**

(30) Priority: 27.02.2023 JP 2023028061
(71) Applicant: Sony Semiconductor Solutions Corporation, Atsugi-shi, Kanagawa 243-0014 (JP)
(72) Inventor: AOKI, Shumpei, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/004281
(87) International publication number: WO 2024/181074

(57) **Abstract**

Provided are a semiconductor device, an electronic apparatus, and a method for producing a semiconductor device aimed at achieving a low-profile, miniaturized device configuration while ensuring excellent heat dissipation.

This semiconductor device includes: a substrate part having a first plate surface and a second plate surface, both being flat; a semiconductor element having a front surface and a back surface, the semiconductor element being embedded in the substrate part with the front surface facing the first plate surface; and a wiring part electrically connected to the semiconductor element.

## Description

### TECHNICAL FIELD

The present disclosure relates to a semiconductor device, an electronic apparatus, and a method for producing a semiconductor device.

### BACKGROUND ART

It is known that, to semiconductor devices including semiconductor elements (semiconductor chips) such as imaging elements, including CMOS image sensors, or light emitting elements, including semiconductor lasers, for example, a so-called chip on board (CoB) configuration where a semiconductor chip is mounted on a substrate and the semiconductor chip and the substrate are electrically connected by a plurality of wires is applied (see, for example, Patent Document 1).

Furthermore, as a semiconductor device configuration, for example, as disclosed in Patent Document 2, a configuration is known where a circuit board on which an imaging element is mounted has a recess, the imaging element is set in the recess, and the circuit board and the imaging element are electrically connected by bonding wires. Furthermore, as another configuration, for example, as disclosed in Patent Document 3, a configuration is known where a light transmitting member is placed to cover a through opening provided in a substrate from one side, and a semiconductor chip (optical element chip) is placed to cover the opening from the other side. Furthermore, as still another configuration, for example, as disclosed in Patent Document 4, a configuration is known where a plurality of semiconductor elements is arranged on a surface of a central region of a substrate, a peripheral region of the substrate is a thin plate portion that is thinner than the central region, and a wiring board is placed on the thin plate portion.

### CITATION LIST

### PATENT DOCUMENT

Patent Document 1: WO 2021/241053 A
Patent Document 2: Japanese Patent Application Laid-Open No. 2008-187554
Patent Document 3: Japanese Patent Application Laid-Open No. 2006-147916
Patent Document 4: Japanese Patent Application Laid-Open No. 2020-88066

### SUMMARY OF THE INVENTION

### PROBLEMS TO BE SOLVED BY THE INVENTION

The known semiconductor device configurations described above have the following problems. First, according to the CoB configuration as disclosed in Patent Document 1, a frame used for mounting a seal glass that protects the semiconductor chip and a lens forming an optical system for the semiconductor chip is provided on the substrate. This configuration, however, leads to an increase in the overall thickness of the package structure of the semiconductor device. Furthermore, according to the CoB configuration, a heat dissipation path from the semiconductor chip, which is a heat-generating element, is restricted to the downward direction corresponding to the side where the semiconductor chip is attached to the substrate, which makes it difficult to achieve excellent heat dissipation.

Furthermore, according to the configuration as disclosed in Patent Document 2, it is necessary to secure the formation area of the recess for accommodating the imaging element in the substrate, which makes it difficult to miniaturize the substrate. Furthermore, according to the configuration as disclosed in Patent Document 3, the semiconductor chip and the light transmitting member are placed on both sides of the substrate having the opening, which leads to an increase in the overall thickness of the package structure. Furthermore, according to the configuration as disclosed in Patent Document 4, the thin plate portion used for placing the wiring board in the peripheral region of the substrate is provided, which makes it difficult to secure the mounting area for the semiconductor element while miniaturizing the substrate.

It is therefore an object of the present technology to provide a semiconductor device, an electronic apparatus, and a method for producing a semiconductor device aimed at achieving a low-profile and miniaturized device configuration while ensuring excellent heat dissipation.

### SOLUTIONS TO PROBLEMS

A semiconductor device according to the present technology includes: a substrate part having a first plate surface and a second plate surface, both being flat; a semiconductor element having a front surface and a back surface, the semiconductor element being embedded in the substrate part with the front surface facing the first plate surface; and a wiring part electrically connected to the semiconductor element.

In another aspect of the semiconductor device according to the present technology, the semiconductor device further includes a protection part provided to cover the front surface of the semiconductor element.

In another aspect of the semiconductor device according to the present technology, the wiring part includes: a front-surface-side wiring part provided along the first plate surface; a back-surface-side wiring part provided along the second plate surface; and a through-wiring part formed to extend through the substrate part in a plate thickness direction and electrically connecting the front-surface-side wiring part and the back-surface-side wiring part.

In another aspect of the semiconductor device according to the present technology, the substrate part includes: a substrate body having a plate shape and serving as a formation portion where the wiring part is formed; a first covering part having an insulating property and forming the first plate surface by covering a plate surface on a front surface side of the substrate body and the front-surface-side wiring part; and a second covering part having an insulating property and forming the second plate surface by covering a plate surface on a back surface side of the substrate body and the back-surface-side wiring part.

In another aspect of the semiconductor device according to the present technology, the through-wiring part forms a hole extending through the substrate body in a plate thickness direction, and a resin part including a resin material filling the hole is provided in the hole.

In another aspect of the semiconductor device according to the present technology, the semiconductor device further includes a heat dissipation part provided in the substrate part while being in contact with the semiconductor element, the heat dissipation part including a material that has higher thermal conductivity than a material of the substrate part.

In another aspect of the semiconductor device according to the present technology, a through-hole is formed to extend through the substrate part in a plate thickness direction.

In another aspect of the semiconductor device according to the present technology, an external connection terminal is provided on the second plate surface of the substrate part.

An electronic apparatus according to the present technology includes a semiconductor device, the semiconductor device including: a substrate part having a first plate surface and a second plate surface, both being flat; a semiconductor element having a front surface and a back surface, the semiconductor element being embedded in the substrate part with the front surface facing the first plate surface; and a wiring part electrically connected to the semiconductor element.

A method for producing a semiconductor device according to the present technology includes: forming a protection part provided on a front surface side of a semiconductor element; electrically connecting the semiconductor element to a wiring film including a wiring material with the front surface side facing the wiring film; forming a substrate body for the wiring film and the semiconductor element while ensuring that the semiconductor element is embedded in the substrate body; forming a back-surface-side wiring film covering a back surface side of the substrate body; forming a front-surface-side wiring part using the wiring film, a back-surface-side wiring part using the back-surface-side wiring film, and a through-wiring part electrically connecting the front-surface-side wiring part and the back-surface-side wiring part; and covering each of a plate surface on a front surface side of the substrate body and the front-surface-side wiring part, and a plate surface on the back surface side of the substrate body and the back-surface-side wiring part with an insulating material.

### BRIEF DESCRIPTION OF DRAWINGS

Fig. 1 is a side cross-sectional view of a configuration of a solid-state imaging device according to a first embodiment of the present technology.
Fig. 2 is an enlarged view of section A in Fig. 1.
Fig. 3 is a diagram for describing a method for producing the solid-state imaging device according to the first embodiment of the present technology.
Fig. 4 is a diagram for describing the method for producing the solid-state imaging device according to the first embodiment of the present technology.
Fig. 5 is a diagram for describing the method for producing the solid-state imaging device according to the first embodiment of the present technology.
Fig. 6 is a diagram for describing another example of the method for producing the solid-state imaging device according to the first embodiment of the present technology.
Fig. 7 is a diagram for describing the other example of the method for producing the solid-state imaging device according to the first embodiment of the present technology.
Fig. 8 is a side cross-sectional view of an application example of the solid-state imaging device according to the first embodiment of the present technology.
Fig. 9 is a side cross-sectional view of a configuration of a solid-state imaging device according to a second embodiment of the present technology.
Fig. 10 is a side cross-sectional view of a configuration of a solid-state imaging device according to a third embodiment of the present technology.
Fig. 11 is a side cross-sectional view of a configuration of a solid-state imaging device according to a fourth embodiment of the present technology.
Fig. 12 is a side cross-sectional view of an application example of the solid-state imaging device according to the fourth embodiment of the present technology.
Fig. 13 is a block diagram illustrating a configuration example of an electronic apparatus including the solid-state imaging device according to the embodiments of the present technology.

### MODE FOR CARRYING OUT THE INVENTION

The present technology is aimed at achieving a low-profile, miniaturized semiconductor module while ensuring excellent heat dissipation using a configuration where a semiconductor element is embedded in a substrate part and the front and back surfaces of the substrate part are flat.

Hereinafter, modes for carrying out the present technology (hereinafter referred to as "embodiments") will be described with reference to the drawings. Note that the drawings are schematic, and dimensional ratios and the like of each part do not necessarily match those of the actual part. Furthermore, it goes without saying that dimensional relationships and ratios are partly different between the drawings. In the embodiments to be described below, an imaging device (solid-state imaging device) including a solid-state imaging element that is an example of a semiconductor element will be described as an example of a semiconductor device. Note that the embodiments will be described in the following order.
1. Configuration example of solid-state imaging device according to first embodiment
2. Method for producing solid-state imaging device according to first embodiment
3. Another example of method for producing solid-state imaging device according to first embodiment
4. Application example of solid-state imaging device according to first embodiment
5. Configuration example of solid-state imaging device according to second embodiment
6. Configuration example of solid-state imaging device according to third embodiment
7. Configuration example of solid-state imaging device according to fourth embodiment
8. Application example of solid-state imaging device according to fourth embodiment
9. Configuration example of electronic apparatus

### <1. Configuration example of solid-state imaging device according to first embodiment>

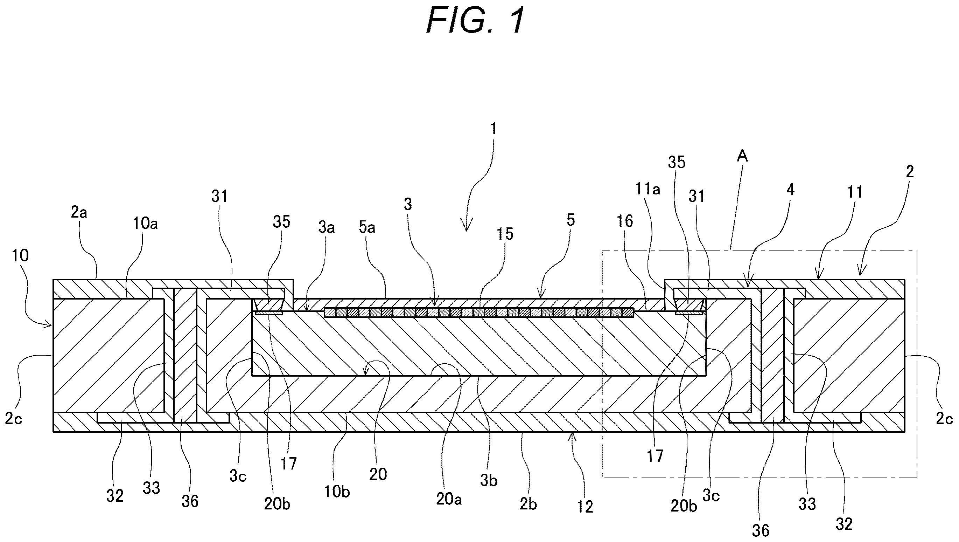

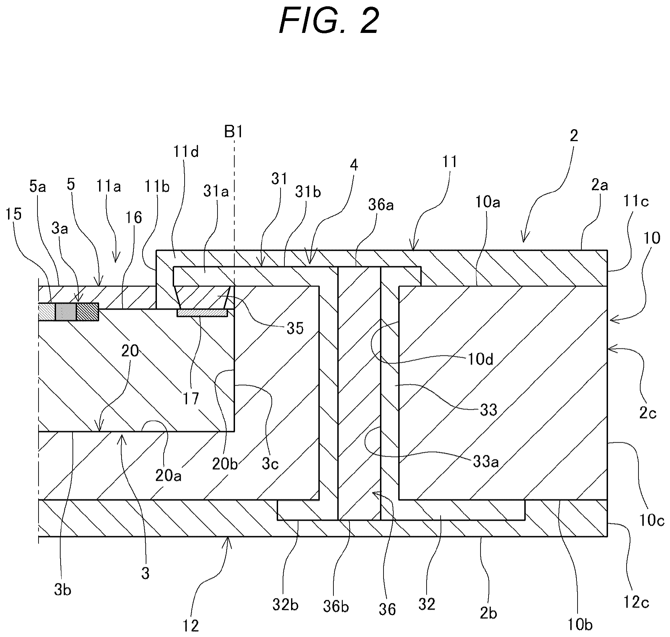

A configuration example of a solid-state imaging device according to a first embodiment of the present technology will be described with reference to Figs. 1 and 2. Note that the upper and lower sides of Fig. 1 corresponds to the upper and lower sides of the solid-state imaging device 1.

As illustrated in Fig. 1, the solid-state imaging device 1 includes a substrate part 2, an image sensor 3 as a solid-state imaging element provided in the substrate part 2, and a wiring part 4 electrically connected to the image sensor 3. The solid-state imaging device 1 further includes a protection part 5 provided on the image sensor 3. The solid-state imaging device 1 has an overall rectangular plate-shaped outline. However, the outline of the solid-state imaging device 1 is not specifically limited.

The substrate part 2 is a base that constitutes the majority of the outline of the solid-state imaging device 1, and has a substrate front surface 2a as a first plate surface and a substrate back surface 2b as a second plate surface. The substrate front surface 2a and the substrate back surface 2b are both flat. The plate thickness direction of the substrate part 2 corresponds to the vertical direction of the solid-state imaging device 1, the substrate front surface 2a corresponds to the upper surface of the substrate part 2, and the substrate back surface 2b corresponds to the lower surface. Furthermore, the substrate part 2 has four side surfaces 2c. The substrate front surface 2a, the substrate back surface 2b, and the side surfaces 2c correspond to the upper surface, lower surface, and side surfaces of the solid-state imaging device 1, respectively.

The substrate part 2 has a configuration where a plate-shaped substrate body 10 has both plate surfaces covered with a front-surface-side covering part 11 and a back-surface-side covering part 12, both serving as insulating portions. That is, the substrate part 2 includes the plate-shaped substrate body 10, the front-surface-side covering part 11, and the back-surface-side covering part 12, the front-surface-side covering part 11 being a first covering part that is formed on an upper surface 10a of the substrate body 10 to serve as the substrate front surface 2a, the back-surface-side covering part 12 being a second covering part that is formed on a lower surface 10b of the substrate body 10 to serve as the substrate back surface 2b.

The substrate body 10 is a plate-shaped formation portion where the wiring part 4 is formed. That is, the wiring part 4 is formed in the substrate body 10 of the substrate part 2. The substrate body 10 has four side surfaces 10c perpendicular to both the upper surface 10a and the lower surface 10b.

The substrate body 10 is, for example, a portion formed by laminating prepregs, which are sheet-like members obtained by impregnating a fiber material such as carbon fibers with a matrix resin such as an epoxy resin, a portion including an organic material such as a glass epoxy resin, which is a type of fiber-reinforced plastic, or the like. Alternatively, the substrate body 10 may be a portion including another type of substrate such as a ceramic substrate including ceramics such as alumina (Al2O3), aluminum nitride (AlN), or silicon nitride (Si3N4) as a base material or a glass substrate using glass.

The image sensor 3 is a semiconductor element including a semiconductor substrate including silicon (Si), which is an example of a semiconductor. The image sensor 3 is a rectangular plate-shaped semiconductor chip, a front surface 3a of the image sensor 3, which is one of the plate surfaces, serves as a light receiving surface, and the other plate surface on the other side of image sensor 3 is a back surface 3b. The image sensor 3 has four side surfaces 3c.

A plurality of light receiving elements (photoelectric conversion elements) is formed on the front surface 3a of the image sensor 3. The image sensor 3 is a complementary metal oxide semiconductor (CMOS) image sensor. Alternatively, the image sensor 3 may be another imaging element such as a charge coupled device (CCD) image sensor.

The image sensor 3 includes, on the front surface 3a, a pixel region 15 that is a light receiving region in which a large number of pixels are formed, and a peripheral region 16 that is a region around the pixel region 15. In the pixel region 15, the large number of pixels are formed in a predetermined arrangement pattern such as a Bayer arrangement, and form a light receiving part in the image sensor 3. Each of the pixels in the pixel region 15 includes a photodiode as a photoelectric converter having a photoelectric conversion function, and a plurality of pixel transistors. A predetermined peripheral circuit is formed in the peripheral region 16. Signals processed by the peripheral circuit are output through the wiring part 4.

On the front surface 3a of the image sensor 3, a color filter and an on-chip lens are individually formed for each pixel with an antireflection film including, for example, an oxide film, a planarization film including an organic material, and the like, interposed between the semiconductor substrate and the color filter and on-chip lens. Light incident on the on-chip lens is received by the photodiode through the color filter, the planarization film, and the like.

On the front surface 3a of the image sensor 3, a plurality of connection pads 17 is formed, each of the connection pad 17 serving as an electrode for receiving electrical connections to the substrate part 2. The connection pad 17 is an electrode that is provided on the front surface 3a of the image sensor 3 and receives electrical connections from the wiring part 4. The connection pad 17 is formed to be exposed on the front surface 3a.

The plurality of connection pads 17 is formed in a predetermined arrangement in the peripheral region 16 on the front surface 3a of the image sensor 3. The plurality of connection pads 17 is provided in the peripheral edge portion of the front surface 3a of the image sensor 3 so as to be arranged along the four sides of the image sensor 3, for example. The arrangement of the connection pads 17, however, is not specifically limited. For example, the plurality of connection pads 17 may be arranged along a pair of mutually opposing sides of the image sensor 3.

Note that the configuration of the image sensor 3 according to the present technology is not specifically limited. Examples of the configuration of the image sensor 3 include a front side illumination type in which the pixel region 15 is formed on the front surface side of the semiconductor substrate, a back side illumination type in which photodiodes and the like are arranged on the opposite side, and the back surface side of the semiconductor substrate serves as a light receiving surface in order to increase light transmittance, and the like.

The image sensor 3 as described above has the front surface 3a and the back surface 3b, and is embedded in the substrate part 2 with the front surface 3a facing the substrate front surface 2a of the substrate part 2. The image sensor 3 is provided in a manner where it is fitted into the recess 20 provided in the substrate body 10. The image sensor 3 is embedded in the substrate part 2 with a portion other than the peripheral edge portion of the front surface 3a exposed. Then, the front surface 3a of the image sensor 3 is positioned lower than the substrate front surface 2a of the substrate part 2.

The recess 20 has a shape and dimensions that match the outline of the image sensor 3. The recess 20 forms a space opened on the upper surface 10a of the substrate body 10, and has a rectangular opening shape corresponding to the outline of the image sensor 3. The recess 20 is formed, for example, in a central portion of the substrate part 2 as viewed from above.

The recess 20 has a bottom surface 20a along the plate surface of the substrate body 10 and four inner side surfaces 20b perpendicular to the bottom surface 20a. In such a recess 20, the image sensor 3 is provided with the back surface 3b and the four side surfaces 3c in full contact with the bottom surface 20a and the four inner side surfaces 20b, respectively. That is, the image sensor 3 is provided with the surfaces other than the front surface 3a in full contact with the substrate body 10 without leaving gaps relative to each of the bottom surface 20a and the four inner side surfaces 20b of the recess 20.

The depth of the recess 20, that is, the vertical dimension of the inner side surface 20b is approximately the same as the thickness of the image sensor 3. Specifically, the depth of the recess 20 is slightly larger than the thickness of the image sensor 3, and the front surface 3a of the image sensor 3 is positioned slightly lower than the upper surface 10a of the substrate body 10.

The wiring part 4 includes a front-surface-side wiring part 31 provided along the substrate front surface 2a, a back-surface-side wiring part 32 provided along the substrate back surface 2b, and a through-wiring part 33 formed to extend through the substrate part 2 in the plate thickness direction and electrically connecting the front-surface-side wiring part 31 and the back-surface-side wiring part 32. The front-surface-side wiring part 31, the back-surface-side wiring part 32, and the through-wiring part 33 form the wiring part 4, which is a continuous integral wiring portion.

The wiring part 4 is formed as a metal film including a metal material such as copper (Cu), aluminum (Al), gold (Au), silver (Ag), tungsten (W), platinum (Pt), or nickel (Ni). The wiring part 4 is formed by, for example, plating, sputtering, or the like.

The front-surface-side wiring part 31 is formed in a predetermined wiring pattern on and along the upper surface 10a of the substrate body 10. The front-surface-side wiring part 31 has one end electrically connected to the connection pad 17 of the image sensor 3 via a bump 35. The front-surface-side wiring part 31 has a plurality of ends, each connected to a corresponding one of the plurality of connection pads 17 via the bump 35.

The bump 35 is a connection terminal for electrically connecting the wiring part 4 to the image sensor 3, and has, for example, a disk-shaped or rectangular-shaped outline. The bump 35 is a metal portion including, for example, copper, an alloy containing copper, gold, or the like. The bump 35 is formed by plating, sputtering, vapor deposition, or the like. Note that the bump 35 may be, for example, a portion including a solder ball, or may have a layered structure including a metal layer such as copper and a solder layer.

The bump 35 has its lower side electrically connected to the corresponding connection pad 17 of the image sensor 3 and has its upper side electrically connected to the corresponding inner end of the front-surface-side wiring part 31. The vertical dimension of the bump 35 corresponds to the size of a step (difference in height position) between the front surface 3a (peripheral region 16) of the image sensor 3 and the upper surface 10a of the substrate body 10.

Specifically, the front-surface-side wiring part 31 is formed as a film-like portion with a predetermined thickness, and includes a pad connection part 31a which is a portion extending inward relative to the inner side surface 20b of the recess 20 provided in the substrate body 10 (see Fig. 2). The pad connection part 31a is a portion of the front-surface-side wiring part 31 protruding inward relative to a position B1 of the inner side surface 20b of the recess 20 (leftward in Fig. 2) in the plane direction perpendicular to the vertical direction.

The pad connection part 31a is individually formed for each connection pad 17. Therefore, the front-surface-side wiring part 31 includes a plurality of the pad connection parts 31a. The plurality of pad connection parts 31a is formed into a sawtooth or comb-like shape (serrated shape) as viewed from above, depending on, for example, the arrangement of the connection pads 17. Each pad connection part 31a is positioned above the corresponding connection pad 17 and is aligned with the connection pad 17 as viewed from above. Then, the bump 35 is interposed between the connection pad 17 and the pad connection part 31a, and the connection pad 17 and the pad connection part 31a are electrically connected by the bump 35.

The back-surface-side wiring part 32 is formed in a predetermined wiring pattern on and along the lower surface 10b of the substrate body 10. Components such as capacitors and a resistors, external connection terminals such as solder balls, and the like are provided in a manner where they are electrically connected to the back-surface-side wiring part 32.

The through-wiring part 33 is a wiring part formed to cover the entire inner peripheral surface of a through-hole 10d formed to extend through the substrate body 10 in the vertical direction (thickness direction). The through-wiring part 33 is a tubular wiring part formed with a predetermined thickness (film thickness) on the inner peripheral surface of the through-hole 10d. Therefore, a hole 33a formed by the through-wiring part 33 has a hole shape corresponding to that of the through-hole 10d. The through-hole 10d is, for example, a linear hole with a hole shape such as circular or rectangular as viewed from above.

The through-wiring part 33 has its upper side connected to the front-surface-side wiring part 31 and has its lower side connected to the back-surface-side wiring part 32. In the through-wiring part 33, the hole 33a extends through both the front-surface-side wiring part 31 and the back-surface-side wiring part 32. That is, the front-surface-side wiring part 31 and the back-surface-side wiring part 32 include portions continuous with the upper and lower opening ends of the hole 33a of the through-wiring part 33, respectively.

As described above, the through-wiring part 33 forms the hole 33a extending through the substrate body 10 in the plate thickness direction. Then, in the hole 33a, a resin part 36 including a resin material filling the hole 33a is provided. That is, in the wiring part 4, the hole 33a formed by the through-wiring part 33 is entirely filled with the resin part 36.

The resin part 36 is a linear portion with a cross-sectional shape such as circular or rectangular, depending on the hole shape of the through-hole 10d. The resin part 36 has, as upper and lower end surfaces, an upper end surface 36a flush with an upper surface 31b of the front-surface-side wiring part 31 and a lower end surface 36b flush with a lower surface 32b of the back-surface-side wiring part 32.

The resin part 36 includes an insulating material. The resin material of the resin part 36 is not specifically limited, but is, for example, a thermosetting resin such as an acrylic resin, an epoxy resin, or a urethane resin, or a photosensitive resin such as a UV-curable resin. Note that the through-wiring part 33 may be a hollow portion in the hole 33a, or may be a portion including a metal material filling the through-hole 10d of the substrate body 10 without the hole 33a.

In the configuration where the wiring part 4 is provided in the substrate body 10 as described above, the front-surface-side covering part 11 and the back-surface-side covering part 12 are provided on the upper and lower surface sides of the substrate body 10, respectively. The front-surface-side covering part 11 covers the upper surface 10a which is a plate surface on the front surface side (upper side) of the substrate body 10 and the front-surface-side wiring part 31 to form the flat substrate front surface 2a. The back-surface-side covering part 12 covers the lower surface 10b which is a plate surface on the lower surface side (lower side) of the substrate body 10 and the back-surface-side wiring part 32 to form the flat substrate back surface 2b.

The front-surface-side covering part 11 and the back-surface-side covering part 12 are formed as insulating portions using an insulating material. The front-surface-side covering part 11 and the back-surface-side covering part 12 are formed, for example, by applying a resist material primarily containing resin or the like. Note that the material of the front-surface-side covering part 11 and the back-surface-side covering part 12 is not specifically limited as long as it is an insulating material. Examples of the material of the covering parts include a thermosetting resin such as an acrylic resin, an epoxy resin, or a urethane resin, or a photosensitive resin such as a UV-curable resin.

The front-surface-side covering part 11 is formed on the substrate front surface 2a of the substrate part 2 to ensure that a portion including the entire pixel region 15 of the front surface 3a of the image sensor 3 is exposed. That is, the front-surface-side covering part 11 has an opening 11a extending across the pixel region 15 and the peripheral region thereof as viewed from above. The opening 11a has, for example, a rectangular shape corresponding to the outline of the pixel region 15 as viewed from above, and is formed by four wall surfaces 11b.

The front-surface-side covering part 11 includes a peripheral region covering part 11d which is a portion covering the peripheral region 16 of the front surface 3a of the image sensor 3. The peripheral region covering part 11d is a portion of the front-surface-side covering part 11 extending inward relative to a portion on the upper surface 10a of the substrate body 10 over the front surface 3a of the image sensor 3, and covers a portion where the pad connection part 31a is connected to the connection pad 17 by the bump 35. The peripheral region covering part 11d is a portion of the front-surface-side covering part 11 protruding inward relative to the position B1 of the inner side surface 20b of the recess 20 (leftward in Fig. 2) in the plane direction perpendicular to the vertical direction. An inner end surface of the peripheral region covering part 11d serves as the wall surface 11b of the opening 11a. As described above, the front-surface-side covering part 11 includes the peripheral region covering part 11d that overlaps the peripheral region 16 of the image sensor 3 as viewed from above and covers the connection part where the wiring part 4 is connected to the image sensor 3.

As described above, in the substrate part 2 including the substrate body 10 provided with the front-surface-side covering part 11 and the back-surface-side covering part 12, four side surfaces 11c and 12c of the covering parts and the side surfaces 10c of the substrate body 10 form the flush side surfaces 2c.

The protection part 5 is provided to cover the front surface 3a of the image sensor 3. The protection part 5 is a portion provided on the front surface 3a of the image sensor 3 to cover and protect the pixel region 15, and is formed to cover the pixel region 15 and the peripheral region thereof. The protection part 5 is provided to form a common layer with the surface layer on the upper surface 10a side of the substrate body 10 in the solid-state imaging device 1.

The protection part 5 has a flat upper surface 5a, and is provided to fully close the opening 11a of the front-surface-side covering part 11 that exposes the pixel region 15. The protection part 5 is provided to ensure that the upper surface 5a is positioned flush or nearly flush with the upper surface 10a of the substrate body 10. Therefore, the upper surface 5a of the protection part 5 is positioned lower than the substrate front surface 2a.

In the example illustrated in Fig. 1, the protection part 5 is provided to fill approximately the lower half of the recess formed by the front surface 3a of the image sensor 3 and the four wall surfaces 11b of the front-surface-side covering part 11. The protection part 5 may be provided to ensure that the upper surface 5a is positioned flush with the substrate front surface 2a, or may be provided to ensure that the upper surface 5a is positioned higher than the substrate front surface 2a. However, from the perspective of suppressing, for example, damage to the protection part 5, the protection part 5 is preferably provided to ensure that the upper surface 5a is positioned flush with or lower than the substrate front surface 2a.

The protection part 5 is provided as a transparent portion or a light transmitting portion so as not to obstruct light reception in the pixel region 15 of the image sensor 3. The protection part 5 is a portion including, for example, a transparent resin material such as an acrylic resin, an epoxy resin, a polycarbonate resin, a polyimide resin, or a liquid silicone rubber, or a transparent inorganic material such as SiO2. Furthermore, the protection part 5 may be a plate-shaped transparent member or a light transmitting member bonded with a transparent or light transmitting adhesive (transparent resin). Note that, as the transparent member or the light transmitting member, for example, glass, a plastic plate, a silicon plate, or the like can be used.

### <2. Method for producing solid-state imaging device according to first embodiment>

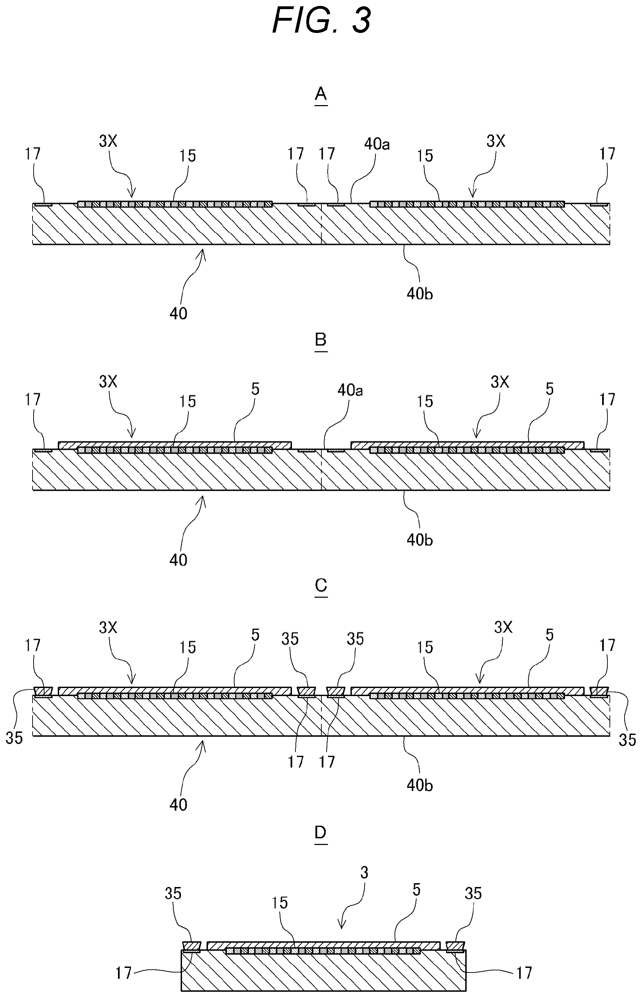

An example of a method for producing the solid-state imaging device 1 according to the first embodiment of the present technology will be described with reference to Figs. 3 to 5.

First, as illustrated in Fig. 3A, a silicon wafer 40 having the pixel region 15 corresponding to each image sensor 3 and a plurality of the connection pads 17 formed on a front surface 40a is prepared. The silicon wafer 40 has undergone various processes for forming the image sensors 3. That is, the silicon wafer 40 is a semiconductor wafer where a plurality of sensor element portions 3X to be the image sensors 3, each having a pixel group formed on one plate surface, is formed in a predetermined arrangement. Note that, a back-grinding (BG) process is performed on the silicon wafer 40 to grind (polish) the silicon wafer 40 from a back surface 40b so as to adjust the silicon wafer 40 to a desired thickness that does not affect device characteristics.

Next, as illustrated in Fig. 3B, a process of forming the protection part 5 covering the pixel region 15 is performed on each sensor element portion 3X. In this process, for example, a transparent resin material forming the protection part 5 is applied to a predetermined region including the entire pixel region 15 and cured to form the protection part 5. Furthermore, for example, the protection part 5 is formed by attaching a transparent member such as a glass plate with a transparent adhesive to cover the entire pixel region 15. The process of forming the protection part 5 on each sensor element portion 3X of the silicon wafer 40 as described above corresponds to a process of forming the protection part 5 provided on the front surface 3a of the image sensor 3.

Next, as illustrated in Fig. 3C, a process of forming the bumps 35 on the plurality of connection pads 17 of each sensor element portion 3X is performed. Each bump 35 includes a metal material such as copper or a copper alloy and is formed by plating, sputtering, vapor deposition, or the like. Furthermore, the bump 35 may be a stud bump formed using, for example, a wire bonding device.

Next, the silicon wafer 40 is diced along a predetermined dicing line using a dicing blade. That is, a process of cutting, along the predetermined arrangement, the silicon wafer 40 into chips, each corresponding to the image sensor 3, is performed. As a result, as illustrated in Fig. 3D, a plurality of the image sensors 3, each having the pixel region 15 covered with the protection part 5, is obtained.

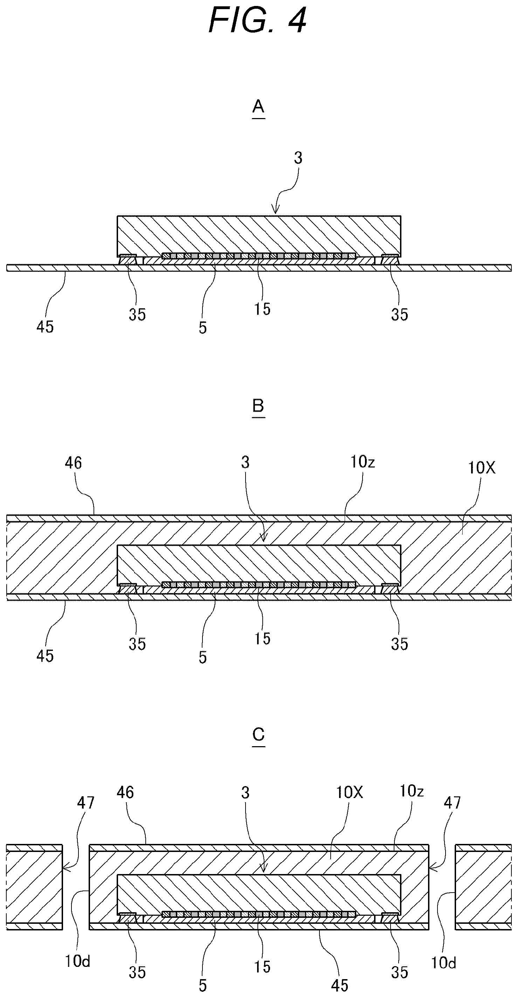

Next, as illustrated in Fig. 4A, a copper foil 45 is prepared, and a process of connecting the image sensor 3 in a face-down orientation onto the copper foil 45 is performed. In this process, with the plurality of image sensors 3 flipped upside down so that the bumps 35 face the copper foil 45, the image sensors 3 are rearranged on the copper foil 45 to connect the bumps 35 to the copper foil 45.

The copper foil 45 has a layered structure including a wiring copper foil that forms the front-surface-side wiring part 31 in the solid-state imaging device 1 and a supporting copper foil that is thicker than the wiring copper foil. Note that, instead of using the copper foil 45, for example, a structure obtained by attaching a copper foil to a plate surface of a support substrate such as glass may be used. The process of rearranging the image sensors 3 on the copper foil 45 corresponds to a process of connecting the image sensors 3 to the copper foil 45 which is a wiring film including a wiring material with the front surface 3a facing the copper foil 45.

Next, as illustrated in Fig. 4B, a process of forming a substrate body 10X for the copper foil 45 and the image sensors 3 while ensuring that each image sensors 3 is embedded is performed. The substrate body 10X is a portion to be the substrate body 10 in the solid-state imaging device 1. The substrate body 10X is formed by, for example, press-laminating a plurality of prepregs including a prepreg with a through-hole corresponding to the image sensor 3.

Note that the method for forming the substrate body 10X is not specifically limited. For example, injection molding using a predetermined resin material may be used to form the substrate body 10X. Furthermore, it is also possible to provide, by using a substrate member having the recess 20 and fitting the image sensor 3 into the recess 20, the substrate body 10X for the image sensor 3. In this case, the copper foil 45 is bonded to the substrate member with adhesive or the like.

Next, as illustrated in Fig. 4B, a process of providing a copper foil 46 on the substrate body 10X is performed. In this process, a plate surface 10z on the side of the substrate body 10X remote from the copper foil 45 is planarized, and then the copper foil 46 is laminated onto the plate surface 10z. The process of forming the copper foil 46 on the substrate body 10X as described above corresponds to a process of forming the copper foil 46 as a back-surface-side wiring film covering the plate surface 10z, which is the back surface side of the substrate body 10X.

Next, a process of forming the front-surface-side wiring part 31 using the copper foil 45, the back-surface-side wiring part 32 using the copper foil 46, and the through-wiring part 33 electrically connecting the front-surface-side wiring part 31 and the back-surface-side wiring part 32 is performed.

Specifically, first, as illustrated in Fig. 4C, a process of forming a through-hole 47 which is a via extending through the substrate body 10X and the upper and lower copper foils 45 and 46 is performed. Of the through-hole 47, a portion formed in the substrate body 10X correspond to the through-hole 10d in the solid-state imaging device 1. Note that when the through-hole 47 is formed, a process of removing the supporting copper foil from the copper foil 45 is performed in advance.

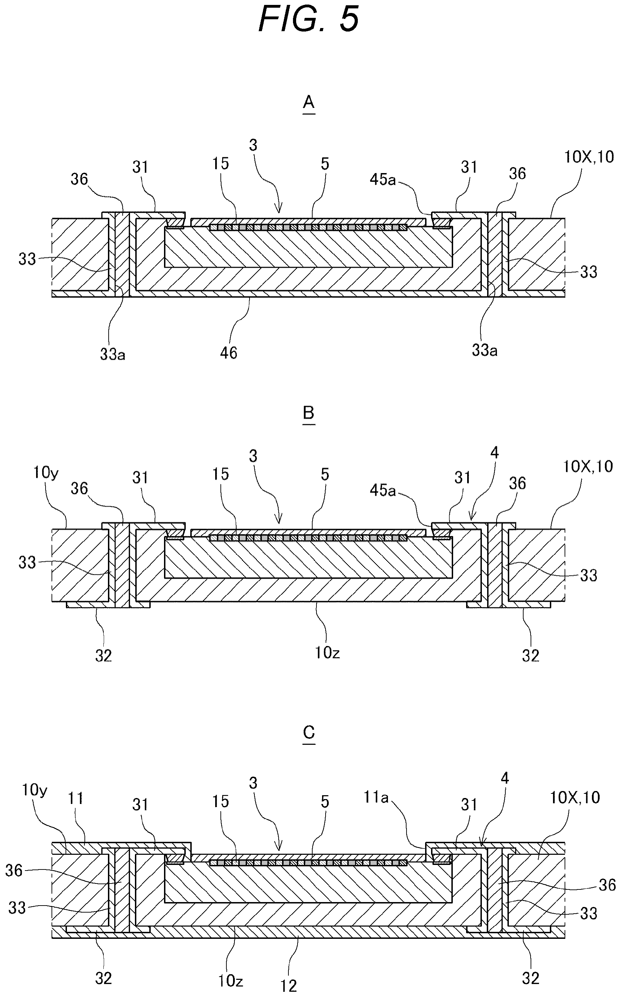

Subsequently, as illustrated in Fig. 5A, a wiring pattern as the front-surface-side wiring part 31 is formed by patterning or the like on the copper foil 45 using a photolithography technique. In the formation of the front-surface-side wiring part 31, an opening 45a is formed in the copper foil 45 to expose the protection part 5 covering the pixel region 15 of the image sensor 3. The opening 45a is formed throughout the entire protection part 5. The opening 45a exposes the pixel region 15 via the protection part 5.

As illustrated in Fig. 5A, the inner peripheral surface of the through-hole 47, the copper foil 45, and the like are plated with a metal material such as copper that forms the wiring part 4, thereby forming the front-surface-side wiring part 31 and the through-wiring part 33. In the example illustrated in Fig. 5A, the through-wiring part 33 is formed with the hole 33a. Note that other methods such as sputtering may be used to form these wiring parts.

Next, as illustrated in Fig. 5A, a process of forming the resin part 36 in the hole 33a of the through-wiring part 33 is performed. The resin part 36 is formed, for example, by filling the hole 33a with a predetermined resin material and curing the resin material.

Next, as illustrated in Fig. 5B, a wiring pattern as the back-surface-side wiring part 32 is formed by patterning or the like on the copper foil 46 using a photolithography technique. Through the above-described processes, the wiring part 4 including the front-surface-side wiring part 31, the back-surface-side wiring part 32, and the through-wiring part 33 is formed, and the resin part 36 is formed in the hole 33a of the through-wiring part 33. Note that, in a case where the resin part 36 is not provided, there is no need to form the hole 33a in the through-wiring part 33, eliminating the need for the process of forming the resin part 36.

Then, a process of covering a plate surface 10y on the front surface side of the substrate body 10X, the front-surface-side wiring part 31, the plate surface 10z on the back surface side of the substrate body 10X, and the back-surface-side wiring part 32 with an insulating material is performed. That is, as illustrated in Fig. 5C, the front-surface-side covering part 11 and the back-surface-side covering part 12 are formed by applying an insulating material such as an acrylic resin to the plate surface 10y and plate surface 10z of the substrate body 10X and curing the insulating material.

Dicing is performed along a predetermined dicing line using a dicing blade on the structure obtained through the above-described processes (see Fig. 5C). That is, a process of cutting the structure into chips, each corresponding to the image sensor 3 and an element portion including the substrate part 2, the wiring part 4, and the protection part 5 provided for the image sensor 3, is performed. As a result, the solid-state imaging device 1 as illustrated in Fig. 1 is obtained.

### <3. Another example of method for producing solid-state imaging device according to first embodiment>

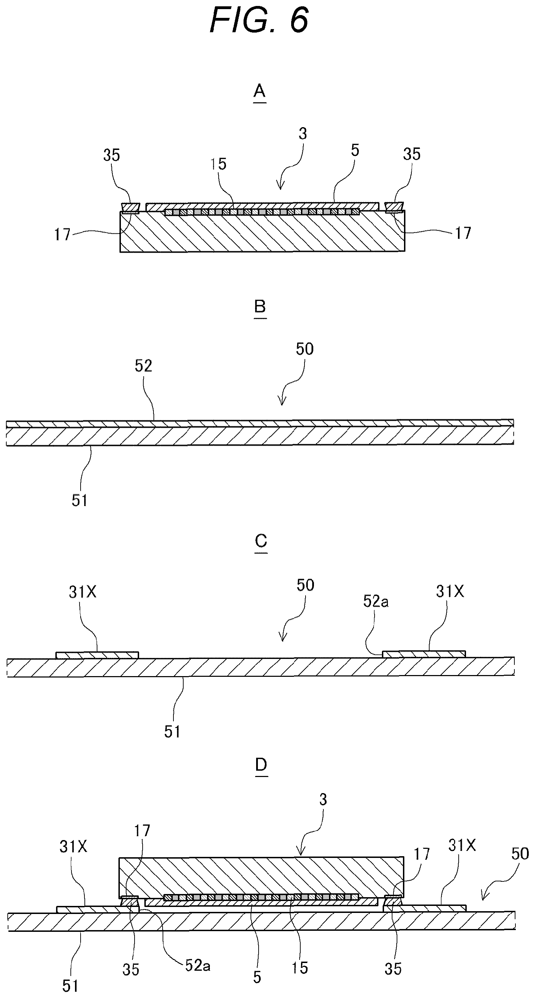

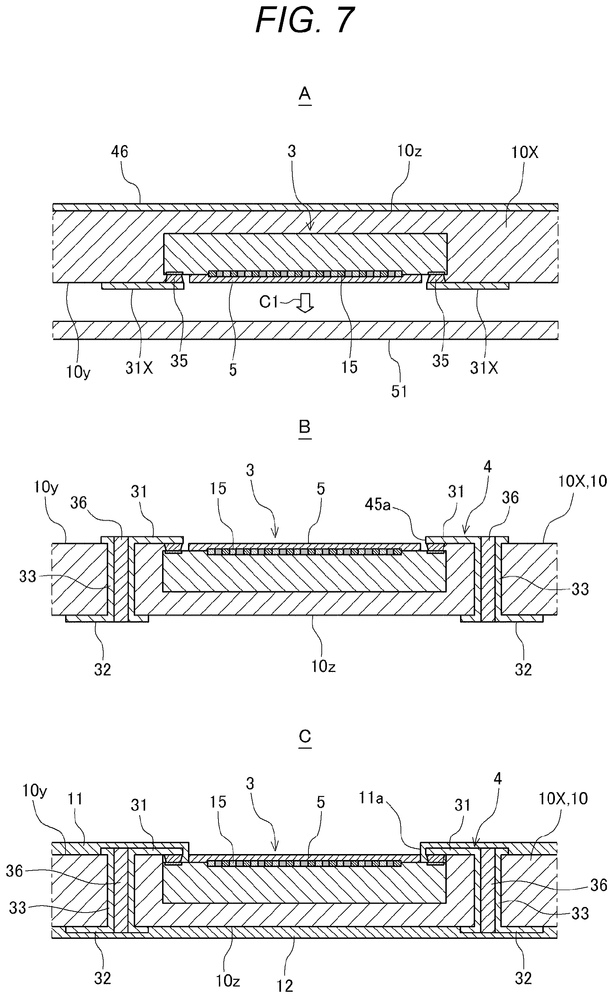

Another example of the method for producing the solid-state imaging device 1 according to the first embodiment of the present technology will be described with reference to Figs. 6 and 7.

In the producing method of this example, first, as illustrated in Fig. 6A, a plurality of the image sensors 3, each including the pixel region 15 covered with the protection part 5 and the bump 35 individually formed for each connection pad 17, is produced through processes similar to the producing method described above.

In the producing method of this example, as illustrated in Fig. 6B, a wiring substrate 50 is used, the wiring substrate 50 including a support substrate 51, which is a flat plate member, and a copper foil 52, which is an example of a wiring material, detachably provided on the support substrate 51. The support substrate 51 is a member that is temporarily used in production and is eventually separated and removed. The support substrate 51 is not particularly limited in terms of material as long as it has a required support strength. The support substrate 51 is, for example, a plate member including an inorganic material such as glass, ceramics, metal, or silicon, or plastic.

The wiring substrate 50 has, for example, a structure where the copper foil 52 is laminated onto the support substrate 51 with a release layer (not illustrated) interposed between the copper foil 52 and the support substrate 51. The release layer has a property of deteriorating adhesive strength through destruction and decomposition when exposed to external energy such as light or heat. The release layer is formed by applying a release material, attaching a sheet-like member such as a release tape, or the like.

Subsequently, as illustrated in Fig. 6C, a wiring pattern as a wiring part 31X to be the front-surface-side wiring part 31 is formed by patterning or the like on the copper foil 52 of the wiring substrate 50 using a photolithography technique. In the formation of the wiring part 31X, an opening 52a is formed in the copper foil 52 to expose the protection part 5 covering the pixel region 15 of the image sensor 3.

Next, as illustrated in Fig. 6D, a process of connecting the image sensor 3 in a face-down orientation onto the wiring part 31X formed on the wiring substrate 50 is performed. In this process, with the plurality of image sensors 3 flipped upside down so that the bumps 35 face the wiring part 31X, the image sensors 3 are rearranged on the wiring substrate 50 to connect the bumps 35 to the wiring part 31X. The process of rearranging the image sensors 3 on the wiring substrate 50 corresponds to a process of connecting the image sensors 3 to the wiring part 31X which is a wiring film including a wiring material with the front surface 3a facing the wiring part 31X.

Subsequently, a process of forming the substrate body 10X for the wiring part 31X and the image sensors 3 while ensuring that each image sensor 3 is embedded and a process of forming the copper foil 46 covering the plate surface 10z of the substrate body 10X are performed in a manner similar to the above-described producing method (see Fig. 7A).

Thereafter, as illustrated in Fig. 7A, a process of releasing the support substrate 51 is performed. That is, in this process, the support substrate 51 is removed from the front-surface-side wiring part 31 and then discarded (see arrow C1). In this process, for example, by irradiating the release layer with light of a predetermined wavelength such as UV light or heating the release layer, the release layer transitions to a state of easy removal, and the support substrate 51 is removed from the front-surface-side wiring part 31 accordingly. In a case where the release layer is irradiated with light, as the support substrate 51, a substrate including a material that transmits light such as glass or a transparent plastic plate is used. Note that as the method for removing the support substrate 51, in addition to light and heat, physical force may be used.

Next, in a manner similar to the above-described producing method, as illustrated in Fig. 7B, a process of forming the front-surface-side wiring part 31 using the wiring part 31X, the back-surface-side wiring part 32 using the copper foil 46, and the through-wiring part 33 electrically connecting the front-surface-side wiring part 31 and the back-surface-side wiring part 32, and a process of forming the resin part 36 are performed. Note that the producing method of this example is different from the above-described producing method in that the wiring part 31X formed on the substrate body 10X is used for the formation of the front-surface-side wiring part 31.

Then, as illustrated in Fig. 7C, a process of forming the front-surface-side covering part 11 and the back-surface-side covering part 12 is performed in a manner similar to the above-described producing method. A dicing process of cutting the structure obtained through the above-described processes into chips, thus obtaining the solid-state imaging device 1 illustrated in Fig. 1.

The solid-state imaging device 1 according to the present embodiment as described above can achieve a low-profile and miniaturized device configuration while ensuring excellent heat dissipation.

The solid-state imaging device 1 eliminates the need to provide glass that protects the image sensor 3, a frame to hold the glass, and the like; thus, it is possible to suppress an increase in the thickness of the solid-state imaging device 1 and achieve a compact device configuration, particularly a low-profile device configuration.

Furthermore, in the solid-state imaging device 1, the image sensor 3 is provided with the back surface 3b and the four side surfaces 3c in full contact with the substrate body 10 forming the substrate part 2. With such a configuration, the heat dissipation path from the image sensor 3, which is a heat-generating element, is not restricted to the downward direction; thus, it is easy to secure the heat dissipation path and achieve excellent heat dissipation. It is therefore possible to maintain the proper operational state of the solid-state imaging device 1 and achieve the desired characteristics.

Furthermore, in the solid-state imaging device 1, the flat substrate front surface 2a is present around the image sensor 3 on the upper side which is the light receiving side of the image sensor 3. With such a configuration, in a case where the solid-state imaging device 1 is used as a camera module substrate incorporating the image sensor 3, the substrate front surface 2a can be used as a mounting surface of a lens mount frame for mounting a lens forming an optical system for the image sensor 3. As a result, the entire camera module system can be made low-profile.

Furthermore, the configuration where the image sensor 3 is embedded in the substrate part 2 and the substrate front surface 2a is flat can bring the lens frame closer to the pixel region 15 of the image sensor 3 while securing the mounting area for the components and the like on the substrate front surface 2a. This allows a reduction in size of the substrate part 2 relative to the image sensor 3, enabling device miniaturization and high-density mounting.

In particular, the front-surface-side covering part 11 forming the substrate front surface 2a has the peripheral region covering part 11d extending over the peripheral region 16 of the image sensor 3 to cover the connection part formed by the bump 35 (see Fig. 2). Such a configuration can bring the substrate front surface 2a as close as possible to the pixel region 15 of the image sensor 3, allowing for efficient miniaturization of the substrate part 2.

Furthermore, the solid-state imaging device 1 includes the protection part 5 that covers the front surface 3a of the image sensor 3. Such a configuration can prevent the pixel region 15 and other devices on the chip surface of the image sensor 3 from being contaminated or damaged by chemicals or external loads during the production of the solid-state imaging device 1.

The wiring part 4 includes the front-surface-side wiring part 31, the back-surface-side wiring part 32, and the through-wiring part 33. Such a configuration can achieve a wiring structure along the outline of the substrate part 2 for the configuration of the connection part where the image sensor 3 is electrically connected to the substrate part 2, which efficiently achieves a miniaturized and low-profile device configuration.

Furthermore, the configuration of the wiring part 4 can achieve a wire bond-less connection structure without bonding wires for the electrical connection of the image sensor 3. It is therefore possible to shorten the wiring length while reducing the pitch of the plurality of connection pads 17 compared to the configuration using wires. These aspects are advantageous for achieving a miniaturized and low-profile device configuration. Furthermore, in the configuration using wires, the wire arrangement portion protrudes from the substrate surface, and it is therefore necessary to enlarge the substrate to secure the mounting area for the lens mount frame. Regarding this point, according to the configuration of the solid-state imaging device 1 of the present embodiment, with the wire bond-less connection structure, it is possible to easily secure the mounting area for the lens mount frame on the substrate front surface 2a without enlarging the substrate part 2.

Furthermore, regarding the wiring structure of the wiring part 4, the resin part 36 that fills the hole 33a of the through-wiring part 33 is provided. Such a configuration can increase the rigidity of the substrate body 10 compared to, for example, the configuration where the hole 33a has a hollow interior, which makes it possible to suppress deformation such as warping of the substrate part 2. Furthermore, according to the configuration where the resin part 36 is provided, it is possible to reduce the metal material of the wiring part 4 compared to the configuration where the hole 33a is filled with the metal material of the through-wiring part 33.

Furthermore, the substrate part 2 includes the substrate body 10, and the front-surface-side covering part 11 and the back-surface-side covering part 12 provided on both plate surfaces of the substrate body 10. According to such a configuration, in the configuration where the front-surface-side wiring part 31 and the back-surface-side wiring part 32 are provided on the upper and lower plate surfaces of the substrate body 10, respectively, the flat substrate front surface 2a and substrate back surface 2b can be easily formed as surfaces to receive the mounting of the lens frame, components, and the like.

### <4. Application example of solid-state imaging device according to first embodiment>

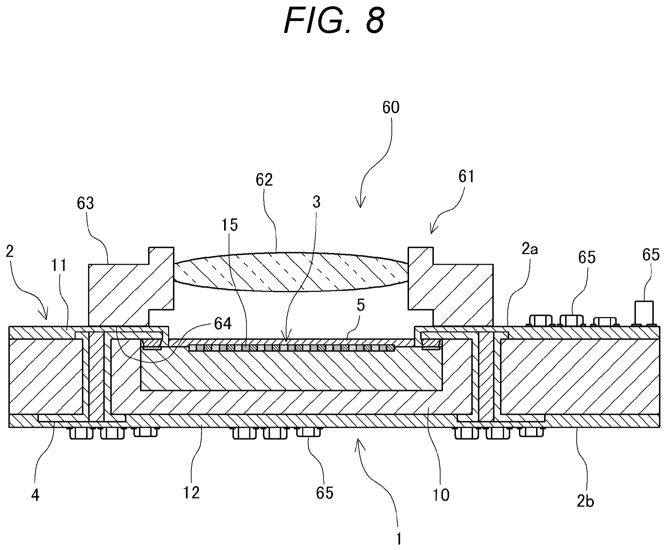

An application example of the solid-state imaging device 1 according to the first embodiment of the present technology will be described with reference to Fig. 8. This application example is an example of a case where the solid-state imaging device 1 is applied as a camera module substrate incorporating the image sensor 3.

As illustrated in Fig. 8, the solid-state imaging device 1 as a camera module substrate has a lens unit 61 mounted on the substrate front surface 2a to constitute a camera module 60. The lens unit 61 forms an image on the image sensor 3 by focusing light from a subject through one or a plurality of lenses 62. The lens unit 61 includes a lens mount frame 63 with a tubular structure, and supports the lens 62 in the frame 63 such that the optical axis of the lens 62 is aligned with the axial direction of the tubular frame 63.

The lens unit 61 is mounted on the solid-state imaging device 1 with an attachment surface 64 on the lower side of the frame 63 attached onto the substrate front surface 2a of the solid-state imaging device 1 with adhesive or the like. In the configuration where the lens unit 61 is provided on the solid-state imaging device 1, light condensed by the lens 62 is incident on the light receiving surface formed by the pixel region 15 of the image sensor 3. Furthermore, in the example illustrated in Fig. 8, a plurality of surface-mounted components 65 such as capacitors and resistors is mounted at predetermined positions on the substrate front surface 2a and substrate back surface 2b of the substrate part 2.

According to this application example, since the frame 63 of the lens unit 61 can be mounted on the substrate front surface 2a, it is possible to make the entire camera module 60 low-profile compared to, for example, the known CoB configuration. Furthermore, the installation position of the frame 63 (the contact position of the attachment surface 64) can be brought closer to the pixel region 15 of the image sensor 3 while securing the mounting area for the surface-mounted components 65 and the like on the substrate front surface 2a. In particular, in the present embodiment, since the front-surface-side covering part 11 forming the substrate front surface 2a has the peripheral region covering part 11d overlapping the image sensor 3, the installation position of the frame 63 can be brought as close as possible to the pixel region 15. This allows a reduction in size of the substrate part 2 relative to the image sensor 3, enabling device miniaturization and high-density mounting.

### <5. Configuration example of solid-state imaging device according to second embodiment>

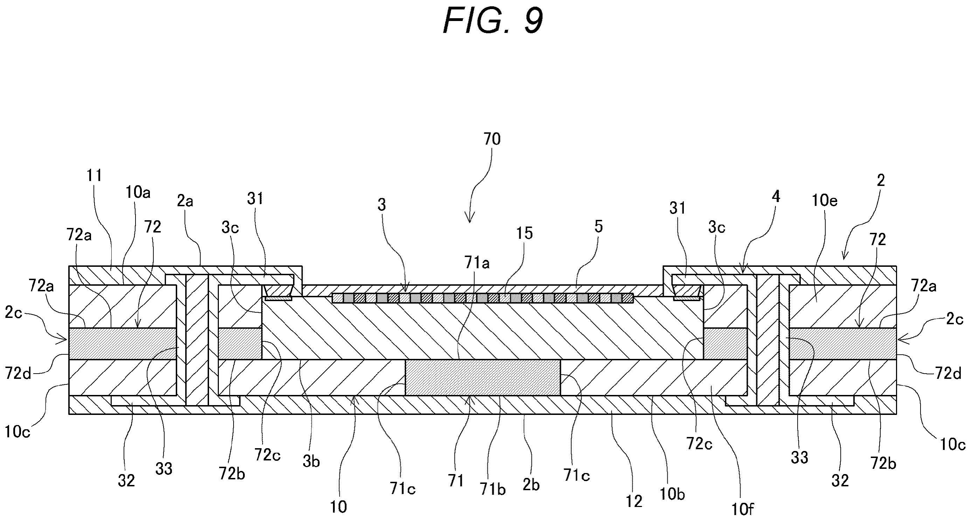

A configuration example of a solid-state imaging device 70 according to a second embodiment of the present technology will be described with reference to Fig. 9. In each embodiment to be described below, the same names or the same reference numerals are used for components common to or corresponding to components of the first embodiment, and the description of the components will be omitted as appropriate.

As illustrated in Fig. 9, the solid-state imaging device 70 according to the present embodiment includes heat dissipation parts (71, 72) including a material having higher thermal conductivity than the material of the substrate part 2. In the present embodiment, the heat dissipation parts (71, 72) include a material having higher thermal conductivity than the material of the substrate body 10 constituting the substrate part 2 and the material of the front-surface-side covering part 11 and back-surface-side covering part 12. The heat dissipation parts (71, 72) are provided in the substrate part 2 while being in contact with the image sensor 3.

The solid-state imaging device 70 includes, as the heat dissipation parts, a first heat dissipation part 71 provided under the image sensor 3 and in contact with the back surface 3b of the image sensor 3, and a second heat dissipation part 72 provided beside the image sensor 3 and in contact with the side surface 3c of the image sensor 3. The first heat dissipation part 71 and the second heat dissipation part 72 are provided while being embedded in the substrate part 2. The first heat dissipation part 71 and the second heat dissipation part 72 are provided by, for example, embedding a heat dissipation member including a metal material in the substrate body 10.

The material of the first heat dissipation part 71 and the second heat dissipation part 72 is not specifically limited, but a material with high thermal conductivity is preferable from the perspective of heat dissipation, and a material with a low linear expansion coefficient is preferable from the perspective of suppressing deformation caused by heat. Examples of the material of the first heat dissipation part 71 and the second heat dissipation part 72 include copper (Cu), a copper alloy, tungsten (W), aluminum (Al), stainless steel (SUS), an Fe-Ni-Co alloy, a 42 alloy, and the like. Note that the first heat dissipation part 71 and the second heat dissipation part 72 may be portions including a material other than a metal material, such as ceramics or resin. Furthermore, the first heat dissipation part 71 and the second heat dissipation part 72 may be portions including the same material or portions including different materials. Furthermore, the first heat dissipation part 71 and the second heat dissipation part 72 may include the same material as that of the wiring part 4.

The first heat dissipation part 71 is configured by placing a rectangular plate-shaped member under the image sensor 3, and has an upper surface 71a, a lower surface 71b, and four side surfaces 71c that are all flat. The first heat dissipation part 71 is provided such that the upper surface 71a is in contact with the back surface 3b of the image sensor 3 and the lower surface 71b is positioned flush with the lower surface 10b of the substrate body 10. Therefore, the lower surface 71b of the first heat dissipation part 71, together with the lower surface 10b of the substrate body 10, forms a surface where the back-surface-side covering part 12 is formed. The side surfaces 71c of the first heat dissipation part 71 are in contact with the substrate body 10.

In the example illustrated in Fig. 9, the first heat dissipation part 71 is provided such that the upper surface 71a is in contact with the central portion of the back surface 3b of the image sensor 3 and is partially in contact with the back surface 3b. However, the first heat dissipation part 71 may have an external dimension that is approximately the same as or larger than that of the image sensor 3 as viewed from above and be provided in full contact with the back surface 3b of the image sensor 3. Furthermore, the first heat dissipation part 71 may be provided while being entirely embedded in the substrate body 10 by positioning the lower surface 71b higher than the lower surface 10b of the substrate body 10 and covering the lower surface 71b with the substrate body 10. Furthermore, the shape of the first heat dissipation part 71 is not specifically limited.

The second heat dissipation part 72 is configured by placing a rectangular plate-shaped member beside the image sensor 3, and has an upper surface 72a, a lower surface 72b, an inner side surface 72c, and an outer side surface 72d that are all flat. The second heat dissipation part 72 is provided such that the inner side surface 72c is in contact with the side surface 3c of the image sensor 3 and the outer side surface 72d is positioned flush with the side surface 10c of the substrate body 10. Therefore, the outer side surface 72d of the second heat dissipation part 72, together with the side surface 10c of the substrate body 10 and the like, forms the side surface 2c of the substrate part 2.

In the example illustrated in Fig. 9, the second heat dissipation part 72 is provided such that the inner side surface 72c is in contact with a part of the side surface 3c, that is, the inner side surface 72c is in contact with the lower part of the side surface 3c of the image sensor 3, with the through-wiring part 33 extending through the second heat dissipation part 72. With this configuration, the second heat dissipation part 72 is interposed between an upper layer part 10e forming the upper surface 10a of the substrate body 10 and a lower layer part 10f forming the lower surface 10b of the substrate body 10. However, the second heat dissipation part 72 may have a vertical dimension (thickness) that is approximately the same as or larger than that of the image sensor 3 and be provided in full contact with the side surface 3c of the image sensor 3. Furthermore, the second heat dissipation part 72 may be provided while being entirely embedded in the substrate body 10 by positioning the outer side surface 72d inward relative to the side surface 10c of the substrate body 10 and covering the outer side surface 72d with the substrate body 10.

Furthermore, the shape of the second heat dissipation part 72 is not specifically limited. The second heat dissipation part 72 may be arranged at a plurality of locations, that is, for each side surface 3c of the image sensor 3 and may be provided as a continuous integral portion with a frame-shaped outline to surround the image sensor 3 as viewed from above, for example. Furthermore, in the example illustrated in Fig. 9, the second heat dissipation part 72 is provided in contact with the through-wiring part 33, but may be provided as a portion not in contact with the through-wiring part 33.

The first heat dissipation part 71 and the second heat dissipation part 72 are provided by laminating, for example, a plate-shaped heat dissipation body forming the first heat dissipation part 71 or the second heat dissipation part 72 together with a plurality of prepregs as one of a plurality of laminates forming the substrate body 10X in the process of forming the substrate body 10X in the above-described method for producing the solid-state imaging device 1 (see Fig. 4B). Furthermore, the first heat dissipation part 71 and the second heat dissipation part 72 may be provided by forming, for example, a space such as a recess in the substrate body 10X and fitting a heat dissipation body forming the first heat dissipation part 71 or the second heat dissipation part 72 into the space in the process of forming the substrate body 10X.

Since the solid-state imaging device 70 according to the present embodiment includes the first heat dissipation part 71 and the second heat dissipation part 72, it is possible to efficiently dissipate heat generated from the image sensor 3, which is a heat-generating element, and enhance heat dissipation characteristics compared to a case where the contact portion that is in contact with the back surface 3b and side surface 3c of the image sensor 3 only includes the substrate body 10.

From the perspective of achieving high heat dissipation through the first heat dissipation part 71 and the second heat dissipation part 72, the second heat dissipation part 72 is preferably provided in contact with the through-wiring part 33. With such a configuration, the wiring part 4 can be used as a heat dissipation path from the image sensor 3. Furthermore, by using a material having higher rigidity than the substrate body 10 as the material of the first heat dissipation part 71 and the second heat dissipation part 72, it becomes easier to ensure the rigidity of the substrate part 2, thereby suppressing deformation of the solid-state imaging device 1. Furthermore, it is only required to provide at least one of the first heat dissipation part 71 or the second heat dissipation part 72. Furthermore, it is only required that the material of the first heat dissipation part 71 and the second heat dissipation part 72 be a material having higher thermal conductivity than the material of at least the substrate body 10 among the substrate body 10, the front-surface-side covering part 11, and the back-surface-side covering part 12 that constitute the substrate part 2.

### <6. Configuration example of solid-state imaging device according to third embodiment>

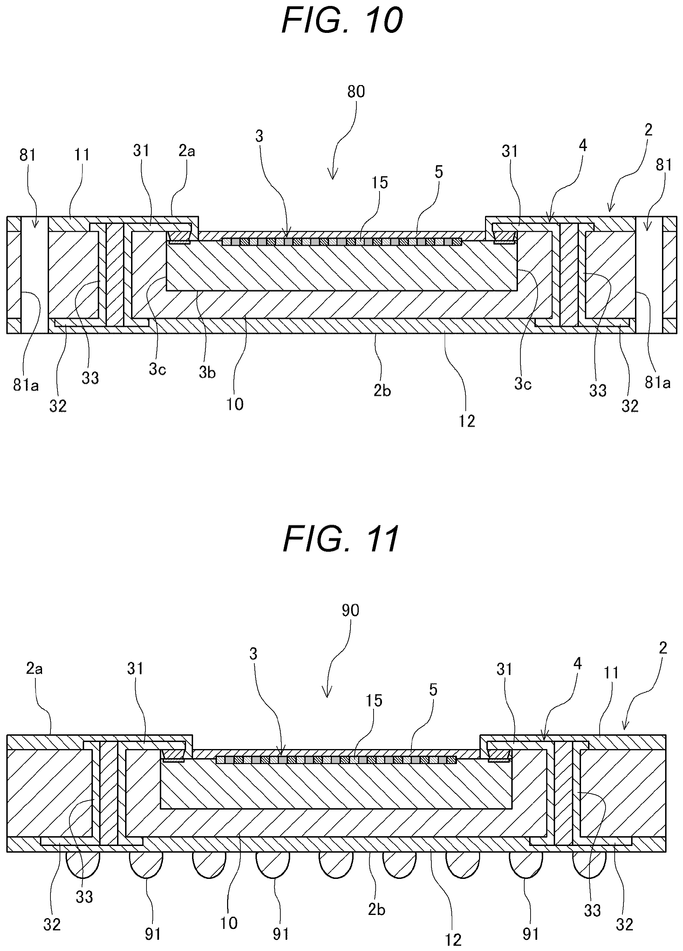

A configuration example of a solid-state imaging device 80 according to a third embodiment of the present technology will be described with reference to Fig. 10.

As illustrated in Fig. 10, in the solid-state imaging device 80 according to the present embodiment, a through-hole 81 is formed to extend through the substrate part 2 in the plate thickness direction. The through-hole 81 is a linear hole extending in the vertical direction, and has a circular hole shape defined by a cylindrical inner peripheral surface 81a as viewed from above. The through-hole 81 is formed to open on both the substrate front surface 2a and the substrate back surface 2b. That is, the through-hole 81 is formed across the substrate body 10, the front-surface-side covering part 11, and the back-surface-side covering part 12 and extends through the substrate part 2.

In the substrate part 2, a plurality of the through-holes 81 is formed in a region outside (outer peripheral side) of the formation area where the wiring part 4 is formed so as not to interfere with the wiring part 4. The plurality of through-holes 81 is formed in an arrangement that is line-symmetrical or point-symmetrical with respect to the outline of the solid-state imaging device 1 as viewed from above, for example.

The through-hole 81 is formed by processing the substrate part 2 after the process of forming the front-surface-side covering part 11 and the back-surface-side covering part 12. For the formation of the through-hole 81, processing techniques such as mechanical machining including drilling and punching, laser processing, and hole-making processing such as etching are appropriately used.

The solid-state imaging device 80 according to the present embodiment allows the through-hole 81 to be used for attaching the solid-state imaging device 80 to an external device. For example, in a camera, in a case where the solid-state imaging device 80 is attached to a frame constituting a lens unit forming an optical system, a housing supporting the lens unit, or the like (hereinafter simply referred to as a "frame"), the through-hole 81 is used as a fastening hole through which a fixing screw passes. For example, the screw is inserted through the through-hole 81 to engage with a threaded hole that is formed on the frame side.

Then, when the solid-state imaging device 80 is attached to an external device, the flat substrate front surface 2a serves as a reference surface, and the solid-state imaging device 80 is fastened and fixed using the through-hole 81, enabling optical axis alignment with the lens unit. That is, as the solid-state imaging device 80 is fastened and fixed to the frame with the screw, the substrate front surface 2a serving as the reference surface comes into contact with the attachment surface serving as a frame-side reference surface to position the solid-state imaging device 80 relative to the frame. Here, the solid-state imaging device 80 is positioned such that the front surface 3a of the image sensor 3 is perpendicular to the optical axis of the lens unit. Furthermore, according to the configuration where the through-hole 81 is provided at a plurality of locations, the positioning (optical axis alignment) of the solid-state imaging device 80 relative to the frame can be performed in a plane direction perpendicular to the optical axis of the lens unit.

### <7. Configuration example of solid-state imaging device according to fourth embodiment>

A configuration example of a solid-state imaging device 90 according to a fourth embodiment of the present technology will be described with reference to Fig. 11.

As illustrated in Fig. 11, in the solid-state imaging device 90 according to the present embodiment, a plurality of solder balls 91 as external connection terminals is provided on the substrate back surface 2b of the substrate part 2. Each solder ball 91 is provided corresponding to a terminal electrode formed on the substrate back surface 2b. The terminal electrode on which the solder ball 91 is placed is electrically connected to a predetermined wiring part formed in the substrate part 2.

The plurality of solder balls 91 is two-dimensionally arranged in a grid pattern along the rectangular outline of the image sensor 3 to form a ball grid array (BGA). The solid-state imaging device 90 is reflow-mounted on a set substrate, which is a circuit board having a predetermined circuit, using the group of solder balls 91.

The plurality of solder balls 91 is provided through a process of forming the plurality of solder balls 91 on the substrate back surface 2b after the process of forming the front-surface-side covering part 11 and the back-surface-side covering part 12. Here, ball mounting is performed to place the solder ball on each of the plurality of terminal electrodes formed on the substrate back surface 2b.

The solid-state imaging device 90 according to the present embodiment can be secondarily mounted on the set substrate, allowing the solid-state imaging device 90 to be used as an image sensor package. Note that, as the external connection terminals, in addition to the solder balls 91, outer leads, connectors (plugs), pins, and the like can be provided.

### <8. Application example of solid-state imaging device according to fourth embodiment>

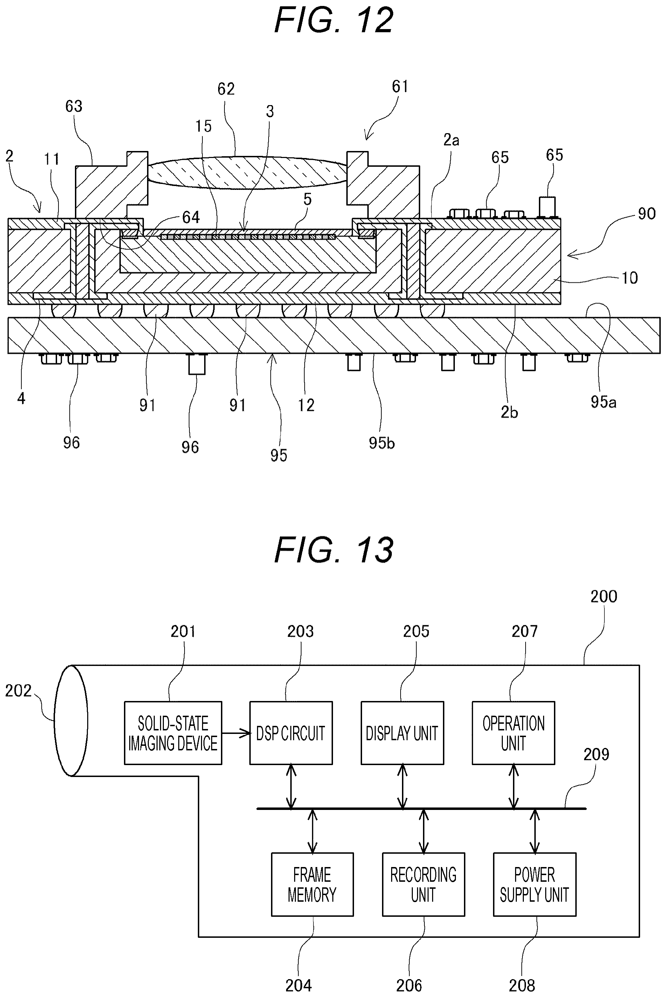

An application example of the solid-state imaging device 90 according to the fourth embodiment of the present technology will be described with reference to Fig. 12. This application example is an example of a case where the solid-state imaging device 90 is used as an image sensor package and applied to a camera device.

As illustrated in Fig. 12, in the camera device, the solid-state imaging device 90 is reflow-mounted on a set substrate 95 using the plurality of solder balls 91 arranged at a predetermined area on the substrate back surface 2b of the substrate part 2. The set substrate 95 is a circuit board including an organic material such as plastic, ceramics, or the like. The set substrate 95 has, for example, a structure where copper wiring is applied to glass epoxy.

The set substrate 95 has a front surface 95a and a back surface 95b, and the solid-state imaging device 90 is mounted on the front surface 95a. Furthermore, on the back surface 95b of the set substrate 95, a plurality of surface-mounted components 96 such as capacitors and resistors are mounted at predetermined positions. Note that the lens unit 61 is mounted on the substrate front surface 2a of the solid-state imaging device 90 in a manner similar to the camera module 60 illustrated in Fig. 8.

As in this application example, by providing the external connection terminals such as the solder balls 91, it is possible to secondarily mount the solid-state imaging device 90 on another substrate such as the set substrate 95, allowing the solid-state imaging device 90 to be used in a package-like manner (in a package form). It is therefore possible to achieve device miniaturization, low-profile design, and high-density mounting compared to package mounting using the known CoB configuration.

### <9. Configuration example of electronic apparatus>

An application example of the semiconductor device according to the above-described embodiments to an electronic apparatus will be described with reference to Fig. 13.

The semiconductor device (solid-state imaging device) according to the present technology can be used as various types of devices that sense light such as visible light, infrared light, ultraviolet light, and X-rays, for example. The solid-state imaging device according to the present technology is applicable to all electronic apparatuses using a solid-state imaging element as an image capturing unit (photoelectric converter), such as a camera device such as a digital still camera or a video camera, a mobile terminal device having an imaging function, a copying machine using a solid-state imaging element as an image reading unit, an in-vehicle sensor that captures images of the front, rear, surroundings, inside, and the like of an automobile, and a ranging sensor that measures a distance between vehicles and the like. Furthermore, the solid-state imaging device may be formed as one chip, or may be in the form of a module having an imaging function in which an imaging unit and a signal processing unit or an optical system are packaged together.

As illustrated in Fig. 13, a camera device 200 as an electronic apparatus includes an optical unit 202, a solid-state imaging device 201, a digital signal processor (DSP) circuit 203, which is a camera signal processing circuit, a frame memory 204, a display unit 205, a recording unit 206, an operation unit 207, and a power supply unit 208. The DSP circuit 203, the frame memory 204, the display unit 205, the recording unit 206, the operation unit 207, and the power supply unit 208 are appropriately connected via a connection line 209 such as a bus line. The solid-state imaging device 201 is any one of the solid-state imaging devices 1, 70, 80, and 90 according to the above-described embodiments.

The optical unit 202 includes a plurality of lenses, and captures incident light (image light) from a subject to form an image on an imaging surface of the solid-state imaging device 201. The solid-state imaging device 201 converts the light amount of the incident light imaged on the imaging surface by the optical unit 202 into an electrical signal for each pixel and outputs the electrical signal as a pixel signal.

The display unit 205 includes, for example, a panel type display device such as a liquid crystal panel or an organic electro luminescence (EL) panel, and displays a moving image or a still image captured by the solid-state imaging device 201. The recording unit 206 records the moving image or the still image captured by the solid-state imaging device 201 on a recording medium such as a hard disk or a semiconductor memory.

The operation unit 207 issues operation commands for various functions of the camera device 200 under user operation. The power supply unit 208 appropriately supplies various power sources serving as operation power sources of the DSP circuit 203, the frame memory 204, the display unit 205, the recording unit 206, and the operation unit 207 to these supply targets.

According to the camera device 200 described above, the solid-state imaging device 201 can achieve a low-profile, miniaturized device configuration while ensuring excellent heat dissipation. Furthermore, achieving the miniaturized and low-profile solid-state imaging device 201 is beneficial from the perspective of downsizing of the camera device 200. Furthermore, achieving excellent heat dissipation in the solid-state imaging device 201 is beneficial from the perspective of maintaining the proper operational state of the camera device 200 and achieving the desired characteristics.

The description of the above-described embodiments is an example of the present technology, and the present technology is not limited to the above-described embodiments. For this reason, it is needless to say that various modifications other than the above-described embodiments can be made according to the design and the like without departing from the technical idea of the present disclosure. Furthermore, the effects described in the present disclosure are merely examples and are not intended to be limiting, and there may also be other effects. Furthermore, the configuration of each of the above-described embodiments and the configuration of each modification can be appropriately combined.

In the above-described embodiments, the semiconductor element is the image sensor 3 that is a light receiving element, but the semiconductor element according to the present technology is not limited to an image sensor. The semiconductor element according to the present technology may be, for example, a light emitting element such as a vertical cavity surface emitting laser (VCSEL), a laser diode, or a light emitting diode (LED). Furthermore, the imaging device as a semiconductor device may have a configuration where multiple semiconductor elements are provided in one chip or a configuration where multiple semiconductor elements are provided as multiple chips.

Note that the present technology may have the following configurations.
(1) A semiconductor device including:
   a substrate part having a first plate surface and a second plate surface, both being flat;
   a semiconductor element having a front surface and a back surface, the semiconductor element being embedded in the substrate part with the front surface facing the first plate surface; and
   a wiring part electrically connected to the semiconductor element.
(2) The semiconductor device according to the above (1), further including:
   a protection part provided to cover the front surface of the semiconductor element.
(3) The semiconductor device according to the above (1) or (2), in which
   the wiring part includes:
   a front-surface-side wiring part provided along the first plate surface;
   a back-surface-side wiring part provided along the second plate surface; and
   a through-wiring part formed to extend through the substrate part in a plate thickness direction and electrically connecting the front-surface-side wiring part and the back-surface-side wiring part.
(4) The semiconductor device according to the above (3), in which
   the substrate part includes:
   a substrate body having a plate shape and serving as a formation portion where the wiring part is formed;
   a first covering part having an insulating property and forming the first plate surface by covering a plate surface on a front surface side of the substrate body and the front-surface-side wiring part; and
   a second covering part having an insulating property and forming the second plate surface by covering a plate surface on a back surface side of the substrate body and the back-surface-side wiring part.
(5) The semiconductor device according to the above (4), in which
   the through-wiring part forms a hole extending through the substrate body in a plate thickness direction, and
   a resin part including a resin material filling the hole is provided in the hole.
(6) The semiconductor device according to any one of the above (1) to (5), further including:
   a heat dissipation part provided in the substrate part while being in contact with the semiconductor element, the heat dissipation part including a material that has higher thermal conductivity than a material of the substrate part.
(7) The semiconductor device according to any one of the above (1) to (6), in which
   a through-hole is formed to extend through the substrate part in a plate thickness direction.
(8) The semiconductor device according to any one of the above (1) to (7), in which
   an external connection terminal is provided on the second plate surface of the substrate part.
(9) An electronic apparatus including:
   a semiconductor device, the semiconductor device including:
   a substrate part having a first plate surface and a second plate surface, both being flat;
   a semiconductor element having a front surface and a back surface, the semiconductor element being embedded in the substrate part with the front surface facing the first plate surface; and
   a wiring part electrically connected to the semiconductor element.
(10) A method for producing a semiconductor device including:
   forming a protection part provided on a front surface side of a semiconductor element;
   electrically connecting the semiconductor element to a wiring film including a wiring material with the front surface side facing the wiring film;
   forming a substrate body for the wiring film and the semiconductor element while ensuring that the semiconductor element is embedded in the substrate body;
   forming a back-surface-side wiring film covering a back surface side of the substrate body;
   forming a front-surface-side wiring part using the wiring film, a back-surface-side wiring part using the back-surface-side wiring film, and a through-wiring part electrically connecting the front-surface-side wiring part and the back-surface-side wiring part; and
   covering each of a plate surface on a front surface side of the substrate body and the front-surface-side wiring part, and a plate surface on the back surface side of the substrate body and the back-surface-side wiring part with an insulating material.

### REFERENCE SIGNS LIST

- 1: Solid-state imaging device (semiconductor device)
- 2: Substrate part
- 2a: Substrate front surface (first plate surface)
- 2b: Substrate back surface (second plate surface)
- 3: Image sensor (semiconductor element)
- 3a: Front surface
- 3b: Back surface
- 4: Wiring part
- 5: Protection part
- 10: Substate body
- 10a: Upper surface
- 10b: Lower surface
- 10y: Plate surface
- 10z: Plate surface
- 10X: Substate body
- 11: Front-surface-side covering part (first covering part)
- 12: Back-surface-side covering part (second covering part)
- 20: Recess
- 31: Front-surface-side wiring part
- 31X: Wiring part (wiring film)
- 32: Back-surface-side wiring part
- 33: Through-wiring part
- 33a: Hole
- 35: Bump
- 36: Resin part
- 45: Copper foil (wiring film)
- 46: Copper foil (back-surface-side wiring film)
- 70: Solid-state imaging device
- 71: First heat dissipation part (heat dissipation part)
- 72: Second heat dissipation part (heat dissipation part)
- 80: Solid-state imaging device
- 81: Through-hole
- 90: Solid-state imaging device
- 91: Solder ball (external connection terminal)
- 200: Camera device (electronic apparatus)
- 201: Solid-state imaging device (semiconductor device)

## Claims

1. A semiconductor device comprising:
a substrate part having a first plate surface and a second plate surface, both being flat;
a semiconductor element having a front surface and a back surface, the semiconductor element being embedded in the substrate part with the front surface facing the first plate surface; and
a wiring part electrically connected to the semiconductor element.

2. The semiconductor device according to claim 1, further comprising:
a protection part provided to cover the front surface of the semiconductor element.

3. The semiconductor device according to claim 1, wherein
the wiring part includes:
a front-surface-side wiring part provided along the first plate surface;
a back-surface-side wiring part provided along the second plate surface; and
a through-wiring part formed to extend through the substrate part in a plate thickness direction and electrically connecting the front-surface-side wiring part and the back-surface-side wiring part.

4. The semiconductor device according to claim 3, wherein
the substrate part includes:
a substrate body having a plate shape and serving as a formation portion where the wiring part is formed;
a first covering part having an insulating property and forming the first plate surface by covering a plate surface on a front surface side of the substrate body and the front-surface-side wiring part; and
a second covering part having an insulating property and forming the second plate surface by covering a plate surface on a back surface side of the substrate body and the back-surface-side wiring part.

5. The semiconductor device according to claim 4, wherein
the through-wiring part forms a hole extending through the substrate body in a plate thickness direction, and
a resin part including a resin material filling the hole is provided in the hole.

6. The semiconductor device according to claim 1, further comprising:
a heat dissipation part provided in the substrate part while being in contact with the semiconductor element, the heat dissipation part including a material that has higher thermal conductivity than a material of the substrate part.

7. The semiconductor device according to claim 1, wherein
a through-hole is formed to extend through the substrate part in a plate thickness direction.

8. The semiconductor device according to claim 1, wherein
an external connection terminal is provided on the second plate surface of the substrate part.

9. An electronic apparatus comprising:
a semiconductor device, the semiconductor device including:
a substrate part having a first plate surface and a second plate surface, both being flat;
a semiconductor element having a front surface and a back surface, the semiconductor element being embedded in the substrate part with the front surface facing the first plate surface; and
a wiring part electrically connected to the semiconductor element.

10. A method for producing a semiconductor device comprising:
forming a protection part provided on a front surface side of a semiconductor element;
electrically connecting the semiconductor element to a wiring film including a wiring material with the front surface side facing the wiring film;
forming a substrate body for the wiring film and the semiconductor element while ensuring that the semiconductor element is embedded in the substrate body;
forming a back-surface-side wiring film covering a back surface side of the substrate body;
forming a front-surface-side wiring part using the wiring film, a back-surface-side wiring part using the back-surface-side wiring film, and a through-wiring part electrically connecting the front-surface-side wiring part and the back-surface-side wiring part; and
covering each of a plate surface on a front surface side of the substrate body and the front-surface-side wiring part, and a plate surface on the back surface side of the substrate body and the back-surface-side wiring part with an insulating material.
